# EUROPÄISCHE PATENTANMELDUNG

(11) **EP 3 754 440 A1**
(43) Veröffentlichungstag der Anmeldung: **23.12.2020**
(21) Anmeldenummer: 19180648.8
(22) Anmeldetag: 17.06.2019
(51) Int. Cl.: G05B 19/05, H01R 9/26, H05K 7/14

(54) **LOGIKANORDNUNG, PERIPHERIESYSTEM UND VERFAHREN ZUM BETRIEB EINES AKTORS**

(71) Anmelder: Siemens Aktiengesellschaft, 80333 München (DE)
(72) Erfinder: Rottmann, Norbert, 76829 Landau (DE); Heck, Simon, 76474 Au am Rhein (DE)

(57) **Zusammenfassung**

Die vorliegende Erfindung betrifft eine Logikanordnung 13 für ein Peripheriesystem 2, insbesondere eines Automatisierungssystems, ein Peripheriesystem 2 und ein Verfahren 14 zum Betrieb eines Aktors 4, insbesondere mithilfe einer solchen Logikanordnung 13. Eine Aufnahmeeinrichtung 6 ist eingerichtet zum Aufnehmen von Eingangssignalen wenigstens eines Sensors 3, und eine Ausgabeeinrichtung 7 ist eingerichtet zur Ausgabe eines Ausgangssignals an einen Aktor 4. Die Ausgabeeinrichtung 7 und die Aufnahmeeinrichtung 6 sind direkt miteinander gekoppelt und die Logikanordnung 13 ist dazu eingerichtet, über die direkte Kopplung das Ausgangssignal auf Grundlage wenigstens eines Eingangssignals zu erzeugen.

## Beschreibung

Die vorliegende Erfindung betrifft eine Logikanordnung für ein Peripheriesystem, insbesondere eines Automatisierungssystems, ein Peripheriesystem und ein Verfahren zum Betrieb eines Aktors.

Zur, insbesondere automatisierten, Steuerung oder Regelung einer Maschine oder Anlage sind speicherprogrammierbare Steuerungen bekannt, welche dazu eingerichtet sind, ein entsprechendes, auch als Anwenderprogramm bezeichnetes Steuerungs- oder Regelungsprogramm auszuführen. Das Steuerungs- oder Regelungsprogramm kann dabei aus mehreren Softwaremodulen bestehen, wobei einzelne Module üblicherweise unterschiedliche Steuerungs- bzw. Regelaufgaben mittels unterschiedlicher Aktoren erfüllen. Zum Beispiel kann ein Modul vorgesehen sein, das erste Sensordaten eines ersten Sensors der Maschine oder Anlage aufnimmt und auf Grundlage dieser ersten Sensordaten beispielsweise ein Ventil steuert, während ein anderes Modul zweite Sensordaten eines zweiten Sensors der Maschine oder Anlage aufnimmt und auf Grundlage dieser zweiten Sensordaten beispielsweise eine Temperiereinrichtung steuert.

Die Sensordaten werden dabei üblicherweise als Eingangssignale über spezifische Aufnahmeeinrichtungen eingelesen, in der speicherprogrammierbaren Steuerung verarbeitet und entsprechende Ausgangssignale über spezifische Ausgabeeinrichtungen an die Aktoren ausgegeben. Zum Beispiel nimmt die speicherprogrammierbare Steuerung dabei logische Verknüpfungen der Eingangssignale vor, die in entsprechenden Ausgangssignalen resultieren.

Die Aufnahme- und Ausgabeeinrichtungen bilden Peripheriekomponenten und sind üblicherweise den Aktoren bzw. Sensoren räumlich zugeordnet. In der Regel sind die Aufnahme- und Ausgabeeinrichtungen über ein Feldbussystem mit der speicherprogrammierbaren Steuerung verbunden. Dabei können mehrere Aufnahme- und Ausgabeeinrichtungen Teil einer dezentralen Station bzw. Schnittstellenstation sein, über die mehrere Sensoren auslesbar bzw. mehrere Aktoren ansteuerbar sind. Die Aufnahme- und Ausgabeeinrichtungen sind üblicherweise an z.B. als sogenannte Klemmblöcke oder Steckplätze ausgebildete Anschlussanordnungen angeschlossen, die wiederum mit Anschlussmodulen verbunden sind, die als Peripheriemodule, wie beispielsweise Ein- und Ausgabemodule, ausgeführt sein können. Die Anschlussmodule sind über einen Rückwandbus der Schnittstellenstation mit einer Kopfbaugruppe verbunden, an welche wiederrum der Feldbus angeschlossen ist.

Es ist eine Aufgabe der vorliegenden Erfindung, den Betrieb von Aktoren zu verbessern, insbesondere eine zeitlich hochauflösende bzw. optimierte Ansteuerung zu ermöglichen.

Diese Aufgabe wird gelöst durch eine Logikanordnung für ein Peripheriesystem, ein Peripheriesystem und ein Verfahren zum Betrieb eines Aktors gemäß den unabhängigen Ansprüchen.

Eine Logikanordnung gemäß einem ersten Aspekt der Erfindung für, insbesondere zur Integration in, ein Peripheriesystem, insbesondere eines Automatisierungssystems, weist eine Aufnahmeeinrichtung zum Aufnehmen von Eingangssignalen wenigstens eines Sensors und eine Ausgabeeinrichtung zur Ausgabe eines Ausgangssignals an einen Aktor auf. Erfindungsgemäß sind die Ausgabeeinrichtung und die Aufnahmeeinrichtung direkt miteinander gekoppelt und die Logikanordnung ist dazu eingerichtet, über die direkte Kopplung das Ausgangssignal auf Grundlage wenigstens eines Eingangssignals zu erzeugen.

Ein Peripheriesystem im Sinne der Erfindung umfasst insbesondere Sensoren, Aktoren, entsprechende Eingabe- und Ausgabeeinrichtungen sowie ein diese Komponenten verbindendes Netzwerk, z.B. einen Feldbus. Ein Peripheriesystem ist vorzugsweise dazu eingerichtet, Prozesswerte eines zu steuernden oder zu regelnden Prozesses bereitzustellen. Dadurch wird der Zugriff einer speicherprogrammierbaren Steuerung auf diese Prozesswerte ermöglicht, die in das Peripheriesystem eingebunden, z.B. mit dem Feldbus verbunden, ist. Entsprechend kann ein Peripheriesystem auch dazu eingerichtet sein, insbesondere von der speicherprogrammierbaren Steuerung erzeugte oder vorgegebene, Stellwerte zur Steuerung oder Regelung des Prozesses an Aktoren übermitteln. Mit anderen Worten kann ein Peripheriesystem dazu eingerichtet sein, die Prozessperipherie, d.h. Sensoren und Aktoren, an ein oder mehrere Automatisierungsgeräte, d.h. speicherprogrammierbare Steuerungen, anzubinden.

Ein Erzeugen eines Ausgangssignals auf Grundlage wenigstens eines Eingangssignals im Sinne der Erfindung ist insbesondere die Verarbeitung des Eingangssignals gemäß einer vorgegebenen Logik, insbesondere einer Steuerung- oder Regellogik, insbesondere in der Weise, dass ein zur Steuerung oder Regelung eines Aktors geeignetes Signal erhalten wird. Ein Eingangssignal, welches einen Prozesswert eines zu steuernden oder zu regelnden Prozesses charakterisiert, kann zum Beispiel gemäß einer vorgegebenen Rechenvorschrift oder eines vorgegebenen Algorithmus verarbeitet werden, um ein Ausgangssignal, welches einen Stellwert des zu steuernden oder zu regelnden Aktors charakterisiert, zu berechnen. Dabei können auch mehrere, gegebenenfalls von mehreren Sensoren aufgenommene, Eingangssignale bzw. die durch sie charakterisierten Prozesswerte miteinander kombiniert, zum Beispiel logisch verknüpft, werden, um das Ausgangssignal oder auch mehrere Ausgangssignale zu erhalten.

Eine direkte Kopplung der Aufnahmeeinrichtung und der Ausgabeeinrichtung im Sinne der Erfindung ist insbesondere eine direkte Verbindung zwischen den beiden Einrichtungen. Die direkte Kopplung kann z.B. mithilfe einer separaten oder privaten Verbindung hergestellt werden, wobei über diese Verbindung ausschließlich Signale von der Aufnahmeeinrichtung an die Ausgabeeinrichtung - gegebenenfalls auch andersherum - übermittelt werden können. Dabei kann die direkte Kopplung z.B. in Form einer seriellen oder parallelen Verbindung, etwa als RS-232-Schnittstelle, anstelle und/oder zusätzlich zu einer konventionellen Verbindung über einen Feldbus oder einen Rückwandbus einer dezentralen Schnittstellenstation bestehen.

Ein Aspekt der Erfindung basiert auf dem Ansatz, die Steuerung eines Aktors auf Grundlage von Eingangssignalen statt vollständig durch eine speicherprogrammierbare Steuerung oder eine andere CPU durch eine Logikanordnung aus einer Ausgaberichtung und einer Aufnahmeeinrichtung auszuführen. Mit anderen Worten kann zumindest ein Teil der Steuerungslogik, die der Steuerung eines Aktors zugrunde liegt, durch eine direkte Kopplung einer Ausgabeeinrichtung und einer Aufnahmeeinrichtung, welche einen z.B. Zusammenschluss der Ausgabe- und Aufnahmeeinrichtung bewirkt, ausgeführt werden.

In bevorzugter Weise ist dabei die Ausgabeeinrichtung dazu eingerichtet, auf Grundlage wenigstens eines Eingangssignals ein Ausgangssignal zu erzeugen. In diesem Fall ist die Aufnahmeeinrichtung vorzugsweise dazu eingerichtet, die aufgenommenen Eingangssignale, gegebenenfalls in vorverarbeiteter oder aufbereiteter Form, über die direkte Kopplung an der Ausgabeeinrichtung bereitzustellen. Das von der Aufnahmeeinrichtung an der Ausgabeeinrichtung bereitgestellte Signal wird auch als Zwischensignal bezeichnet.

Alternativ dazu kann auch die Aufnahmeeinrichtung anstelle der Ausgabeeinrichtung dazu eingerichtet sein, auf Grundlage wenigstens eines Eingangssignals ein Zwischensignal zu erzeugen. Die Ausgebeinrichtung ist dann vorzugsweise dazu eingerichtet, das Zwischensignal als Ausgangssignal an den Aktor weiterzuleiten. Gegebenenfalls kann die Ausgabeeinrichtung das Zwischensignal aber auch, z.B. durch Modifikation oder Anpassung des Zwischensignals, in das eigentliche Ausgangssignal umwandeln.

Durch eine solche Signalverarbeitung über die direkte Kopplung kann die Zeit von der Aufnahme der Eingangssignale bis zur Ausgabe des Ausgangssignals signifikant verkürzt werden, da die Eingangssignale nicht mehr von der Aufnahmeeinrichtung an die speicherprogrammierbare Steuerung übermittelt und, nach entsprechender Verarbeitung, als Steuerungssignal zurück an die Ausgabeeinrichtung übermittelt werden müssen. Eine Zeitersparnis bei der Übermittlung und Verarbeitung der Signale über die direkte Kopplung ist dabei insbesondere möglich, da die Signale dabei z.B. nicht mehr über zyklisch arbeitende Komponenten des Peripheriesystems an eine ebenfalls zyklisch arbeitende speicherprogrammierbare Steuerung übermittelt, dort verarbeitet und dann zurück übermittelt werden müssen. Üblicherweise sind die verschiedenen Zyklen dabei nicht synchronisiert oder zumindest nur mit großem Aufwand zu synchronisieren, wodurch sich Verzögerungen (maximal in Summe aller beteiligten Zyklen) in der Signalverarbeitung oder -übertragung ergeben. Durch die logische Verarbeitung von Eingangssignalen ausschließlich innerhalb der gekoppelten Aufnahme- und Eingabeeinrichtung kann somit zumindest eine Signalverzögerung z.B. durch eine zyklische Feldbusanschaltung sowie eine zyklische Rückwandbusübertragung vermieden werden, und zwar jeweils einmal für die (eingehenden) Eingangssignale und einmal für das (ausgehende) Steuerungssignal. Eine Gesamtzykluszeit, die sich aus allen bei der Übermittlung und Verarbeitung der Eingangs-, Steuerungs- und Ausgangssignale auftretenden Zyklen zusammensetzt, reduziert sich auf ein Minimum. Die Gesamtzykluszeit kann sich in diesem Fall insbesondere aus den Verarbeitungszyklen der Aufnahmeeinrichtung und der Ausgabeeinrichtung sowie einem Übertragungszyklus zwischen den beiden Einrichtungen zusammensetzen.

Die verkürzte Gesamtzykluszeit ermöglicht es auch oder erleichtert es zumindest, den Determinismus der vielen beteiligten Komponenten bzw. ihrer Zyklen zu bestimmen.

Zur logischen Verknüpfung der Eingangssignale, d. h. zu deren Verarbeitung, werden vorzugsweise die Recheneinheiten der Aufnahmeeinrichtung und/oder der Ausgabeeinrichtung verwendet. In bevorzugter Weise können diese Recheneinheiten entsprechend kombiniert bzw. gekoppelt sein bzw. werden. Selbst wenn die Recheneinheiten solcher Komponenten eine vergleichsweise geringe Leistungsfähigkeit bzw. Rechenkapazität aufweisen, können zumindest einfache Steuerung- oder Regellogiken wie z.B. eine Drehzahlregelung realisiert werden.

Eine solche über die direkte Kopplung durchgeführte logische Eingangssignalverknüpfung bzw. Aktorsteuerung oder -regelung ist außerdem vorteilhaft im Hinblick auf die Systemzuverlässigkeit. Selbst wenn z.B. die speicherprogrammierbare Steuerung oder ein Bussystem ausfällt, können zumindest kleinere Automatisierungsaufgaben durch die Logikanordnung weiter ausgeführt werden. Insgesamt kann also die Verfügbarkeit solcher (Teil-)Aufgaben, zum Beispiel einer schnellen Regelung, wesentlich erhöht werden.

Nachfolgend werden bevorzugte Ausführungsformen der Erfindung und deren Weiterbildungen beschrieben, die jeweils, soweit dies nicht ausdrücklich ausgeschlossen wird, beliebig miteinander sowie mit den im Weiteren beschriebenen Aspekten der Erfindung kombiniert werden können.

In einer bevorzugten Ausführungsform ist die Logikanordnung dazu eingerichtet, die Aufnahmeeinrichtung und die Ausgabeeinrichtung als logische Einheit zu betreiben. Insbesondere können die Aufnahmeeinrichtung und die Ausgabeeinrichtung dazu ausgebildet sein, als logische Einheit zusammenzuarbeiten. Dabei kann die Aufnahmeeinrichtung zum Beispiel dazu eingerichtet sein, die mehreren aufgenommenen Eingangssignale in einer spezifischen, von der Ausgabeeinrichtung logisch verarbeitbaren Form bereitzustellen. Es ist auch denkbar, dass die Aufnahmeeinrichtung eine logische Vorverarbeitung vornimmt, und die Ausgabeeinrichtung eine logische Weiterverarbeitung ausführt. Alternativ oder zusätzlich können die Aufnahmeeinrichtung und die Ausgabeeinrichtung dazu eingerichtet sein, Signale in einem gemeinsamen Arbeitstakt aufzunehmen, zu verknüpfen und/oder bereitzustellen bzw. auszugeben. Das Betreiben der Aufnahmeeinrichtungen und der Ausgabeeinrichtung als logische Einheit vereinfacht die Systemarchitektur und ermöglicht zum Beispiel eine leichtere Koordination von verschiedenen, durch unterschiedliche Aktoren gesteuerte Prozesse.

In einer weiteren bevorzugten Ausführungsform sind die wenigstens eine Aufnahmeeinrichtung und die Ausgabeeinrichtung über einen Terminalblock direkt miteinander gekoppelt. Dabei ist der Terminalblock vorzugsweise Teil der Logikanordnung. Ein Terminalblock im Sinne der Erfindung ist insbesondere ein zur direkten Kopplung zweier Baugruppen, insbesondere der Aufnahmeeinrichtung und der Ausgabeeinrichtung, eingerichtete Anschlussanordnung, z.B. ein entsprechend ausgebildeter Klemmenblock oder Steckplatz. Der Terminalblock kann entsprechend Leitungsanschlüsse zum Anschluss der Ausgabe- und Aufnahmeeinrichtung aufweisen. Über die Leitungsanschlüsse ist zumindest ein Eingangskanal der Aufnahmeeinrichtung mit einem Ausgangskanal der Ausgabeeinrichtung in der Weise verschaltbar bzw. koppelbar, dass ein von der Aufnahmeeinrichtung über den Eingangskanal aufgenommenes Signal von der Logikanordnung verarbeitet und von der Ausgabeeinrichtung ein entsprechendes Ausgangssignal über den Ausgangskanal ausgegeben werden kann. Der Terminalblock erlaubt so eine physikalisch robuste und signaltechnisch Verbindung der Aufnahme- und Ausgabeeinrichtung, insbesondere bei gleichzeitiger Integration in ein Peripheriesystem.

Vorzugsweise ist die Logikanordnung dazu eingerichtet, von der Aufnahmeeinrichtung aufgenommene Eingangssignale über den Terminalblock direkt, d. h. ohne Umweg und/oder Zwischenverarbeitung, von der Aufnahmeeinrichtungen an die Ausgabeeinrichtung weiterzuleiten oder gegebenenfalls von der Aufnahmeeinrichtung in vorverarbeiteter Form an die Ausgabeeinrichtung auszugeben. Alternativ ist es denkbar, dass die Logikanordnung dazu eingerichtet ist, das auf Grundlage der Eingangssignale von der Aufnahmeeinrichtung erzeugtes Zwischensignal, über den Terminalblock direkt an die Ausgabeeinrichtung zum Erzeugen eines Ausgangssignals zu übermitteln.

In einer weiteren bevorzugten Ausführungsform ist der Terminalblock zur Verbindung mit zwei Anschlussmodulen einer Schnittstellenstation eingerichtet. Die Aufnahmeeinrichtung und die Ausgabeeinrichtung sind dabei in bevorzugter Weise jeweils an dem Terminalblock angeschlossen. Zu diesem Zweck weist der Terminalblock Anschlüsse zum Anschluss an zwei Anschlussmodule und einem durch die Anschlussmodule geführten Rückwandbus auf. Der Terminalblock kann insbesondere zum Einstecken in zwei direkt benachbart angeordnete Anschlussanordnungen eingerichtet sein. Dazu kann der Terminalblock z.B. die doppelte Breite einer konventionellen Anschlussanordnung, z.B. eines konventionellen Klemmenblocks, aufweisen. Das Vorsehen eines solchen, mit zwei Anschlussmodulen verbundenen Terminalblocks hat den Vorteil, dass die Aufnahmeeinrichtungen und/oder Ausgabeeinrichtungen bei Bedarf, je nach Anforderung, ausgetauscht werden und auch die neu angeschlossenen Aufnahmeeinrichtungen und/oder Ausgabeeinrichtungen als logische Einheit zusammenarbeiten können. Dies ermöglicht eine weitgehend freie Konfigurierbarkeit der Logikanordnung und damit eine hohe Flexibilität.

In einer weiteren bevorzugten Ausführungsform sind die Ausgabeeinrichtung und die Aufnahmeeinrichtung jeweils mit einem Terminalblock verbunden. Die beiden Terminalblöcke sind vorzugsweise über ein Verbindungsmittel direkt miteinander gekoppelt. Dadurch ist es insbesondere nicht notwendig, die beiden Anschlussmodule zum Anschluss der Terminalblöcke nebeneinander anzuordnen. Insbesondere ist es sogar denkbar, dass die Aufnahme- und Ausgabeeinrichtung auch in unterschiedlichen Schnittstellenstationen angeordnet sind. Dadurch kann die Logikanordnung besonders flexibel erzeugt bzw. eingesetzt werden.

Das Verbindungsmittel kann beispielsweise ein Kabel sein, das in Leitungsanschlüsse der Terminalblöcke eingesteckt ist. Dabei sind die Terminalblöcke vorzugsweise dazu eingerichtet, Eingangskanäle der Aufnahmeeinrichtung über die entsprechenden Leitungsanschlüsse und das dort eingesteckte Kabel jeweils mit einem entsprechenden Ausgangskanal der Ausgabeeinrichtung in der Weise zu verschalten, dass von der Aufnahmeeinrichtung über den Eingangskanal aufgenommene Signale von der Logikanordnung verarbeitet und ein entsprechendes Ausgangssignal von der Ausgabeeinrichtung über den Ausgangskanal ausgegeben werden kann.

In einer weiteren bevorzugten Ausführungsform weist die Logikanordnung eine hierarchische Struktur auf, wobei entweder die Aufnahmeeinrichtung oder die Ausgabeeinrichtung dazu eingerichtet ist, das wenigstens eine Eingangssignal logisch zu verarbeiten. Insbesondere kann eine der beiden Einrichtungen als hierarchisch höhere Einrichtung ausgebildet sein, während die andere Einrichtung als hierarchisch niedrigere Einrichtung ausgebildet sein kann. Die Erzeugung des Ausgangs- bzw. Zwischensignals, d.h. die Verarbeitungslogik, wird dabei in bevorzugter Weise von der hierarchisch höheren Einrichtung ausgeführt. Dadurch ist es möglich, eine konventionelle Aufnahme- bzw. Ausgabeeinrichtung, die gegebenenfalls nur an die Signalübertragung über die direkte Kopplung angepasst werden muss, in die Logikanordnung einzubinden, da in diesem Fall nur die hierarchisch höhere Einrichtung zur speziellen (logischen) Verarbeitung des Eingangs- bzw. Zwischensignals ausgebildet sein muss.

In einer weiteren bevorzugten Ausführungsform ist wenigstens ein Eingangskanal, über den die Eingangssignale von der Aufnahmeeinrichtung aufgenommen werden, mit einem Ausgangskanal, über den das Ausgangssignal von der Ausgabeeinrichtung ausgegeben wird, direkt, insbesondere seriell oder parallel, gekoppelt. Dabei kann insbesondere ein Terminalblock dazu eingerichtet sein, den wenigstens einen Eingangskanal mit dem Ausgangskanal zu koppeln. Der wenigstens eine Eingangskanal und der Ausgangskanal, zum Beispiel in Form von elektrischen Leitungen zwischen einem Sensor und der Aufnahmeeinrichtungen bzw. zwischen der Ausgabeeinrichtung und einem Aktoren, sind dabei vorzugsweise Teil des Peripheriesystems.

Dabei muss eine mehrkanalige Aufnahme- und/oder Ausgabeeinrichtung nicht vollständig im Koppelbetrieb betrieben werden. Vielmehr ist es denkbar, dass nur ein Teil der vorhandenen Eingangs- und/oder Ausgangskanäle miteinander gekoppelt sind. Die restlichen Kanäle können weiter in einem Standardbetrieb arbeiten.

In einer weiteren bevorzugten Ausführungsform ist die Ausgabeeinrichtung dazu eingerichtet, das Ausgangssignal in einem ersten Betriebszustand in Abhängigkeit eines über das Peripheriesystem empfangenen Steuerungssignals zu erzeugen und in einem zweiten Betriebszustand in Abhängigkeit eines von der Aufnahmeeinrichtung ausgegebenen Zwischensignals zu erzeugen. Dies kann insbesondere vorgesehen sein, wenn die Aufnahmeeinrichtung dazu eingerichtet ist, die logische Verarbeitung des wenigstens einen Eingangssignals vorzunehmen. Vorzugsweise weist die Ausgabeeinrichtung zu diesem Zweck ein Priorisierungsmodul auf, welches dazu eingerichtet ist, die Ausgebeinrichtung vom ersten Betriebszustand in den zweiten Betriebszustand - und/oder andersherum - zu versetzen. Dies kann insbesondere notwendig sein, wenn die Ausgabeeinrichtung keine weitere Logik aufweist, die eine Vorschrift zur Verarbeitung der mit über die direkte Kopplung übertragenen Daten bzw. Signale liefert. Mit anderen Worten dient das Priorisierungsmodul in diesem Fall vorzugsweise als Weiche, über welche die Sollwerte zum Ausgeben von der Ausgabeeinrichtung aufgenommen werden. Alternativ kann das Priorisierungsmodul aber auch dazu eingerichtet sein, z.B. über den Rückwandbus empfangene Steuerungssignale z.B. einer speicherprogrammierbaren Steuerung und die über die direkte Verbindung bzw. Kopplung übertragenen Daten bzw. Signale entsprechend zu verknüpfen. Dies ermöglicht einen besonders flexiblen Einsatz der Logikanordnung.

In einer weiteren bevorzugten Ausführungsform ist die Logikanordnung dazu eingerichtet, Statusinformation in Bezug auf das Ausgangssignal im Peripheriesystem bereitzustellen. Beispielsweise kann die Logikanordnung dazu eingerichtet sein, spezifische Prozesswerte, die bei der logischen Verarbeitung des wenigstens einen Eingangssignals auftreten, erfasst werden und/oder erzeugt werden, an einer speicherprogrammierbaren Steuerung bereitzustellen. Solche Statusinformation kann über die speicherprogrammierbare Steuerung zum Beispiel an einer Beobachtungsstation an einen Benutzer ausgegeben und der gesteuerte bzw. geregelte Prozess somit überwacht werden. Alternativ oder zusätzlich kann die Statusinformation von der speicherprogrammierbaren Steuerung auch zur Steuerung oder Regelung weiterer Aktoren bzw. Prozesse herangezogen werden.

In einer weiteren bevorzugten Ausführungsform ist die Logikanordnung dazu eingerichtet, eine Kompatibilität der wenigstens einen Aufnahmeeinrichtung mit der Ausgabeeinrichtung in Bezug auf die Erzeugung des Ausgangssignals auf Grundlage des wenigstens einen Eingangssignals zu prüfen. Insbesondere kann die Logikanordnung dazu eingerichtet sein, die Aufnahmeeinrichtung und die Ausgabeeinrichtung dahingehend zu prüfen, ob die Logik, gemäß der das Ausgangssignal erzeugt wird, durch diese Einrichtungen ausführbar ist. Beispielsweise kann dabei geprüft werden, ob die Aufnahmeeinrichtung und die Ausgabeeinrichtung als logische Einheit eine vorgegebene logische Verknüpfung mehrerer Eingangssignale ausführen können. Dadurch kann ein zuverlässiger Betrieb der Logikanordnung sichergestellt werden.

Eine Überprüfung der Kompatibilität kann z.B. auf Grundlage einer übermittelten Information bezüglich der Firmwareversion oder der Hardwareversion der entsprechenden Aufnahme- oder Ausgabeeinrichtung durchgeführt werden und ist insbesondere vorteilhaft, wenn die Aufnahmeeinrichtungen und/oder die Ausgabeeinrichtung nicht standardmäßig dazu eingerichtet sind, die logische Verarbeitung auszuführen, d.h. z.B. auch als "normale" Ein-/Ausgabebaugruppen, also ohne Modulkopplung z.B. in Verbindung mit speziellen Terminalblöcken, arbeiten können.

In einer weiteren bevorzugten Ausführungsform ist die Logikanordnung dazu eingerichtet, eine Logik zur Erzeugung des Ausgangssignals auf Grundlage wenigstens eines Eingangssignals über das Peripheriesystem zu laden. Es ist zum Beispiel denkbar, dass die Logik, gemäß der das Ausgabesignal zu erzeugen ist, in einer bereits installierten bzw. eingerichteten Logikanordnung, insbesondere einer bereits installierten bzw. eingerichteten Aufnahme- und/oder Ausgabeeinrichtung, im Nachhinein implementiert wird. Dazu können einem Anwender verschiedene Logikbausteine zur Verfügung gestellt werden, mit denen er die Logikanordnung, insbesondere die Aufnahme- und/oder Ausgabebaugruppe, z.B. bei der Projektierung des Peripheriesystems, nach Bedarf programmieren kann.

Alternativ ist es auch denkbar, dass die Logik zur Erzeugung des Ausgangssignals direkt vom Hersteller der Aufnahme- und/oder Ausgabeeinrichtung in der entsprechenden Baugruppe implementiert wird. Die entsprechende Logik kann insbesondere bereits bei der Fertigung der Aufnahme- und/oder Ausgabeeinrichtung als Firmware oder zumindest ein Teil davon vorgesehen sein. Zudem ist es aber auch denkbar, diese Logik als Firmwareupdate im Nachhinein zu laden.

Ein Peripheriesystem gemäß einem zweiten Aspekt der Erfindung weist eine Logikanordnung gemäß dem ersten Aspekt der Erfindung auf.

Ein Verfahren zum Betreiben eines Aktors gemäß einem dritten Aspekt der Erfindung, insbesondere mithilfe einer Logikanordnung nach dem ersten Aspekt der Erfindung, weist die folgenden Schritte auf: (i) Aufnehmen von Eingangssignalen wenigstens eines Sensors mithilfe einer Aufnahmeeinrichtung; (ii) Erzeugen eines Ausgangssignals auf Grundlage wenigstens eines Eingangssignals; und (iii) Ausgeben des wenigstens einen Ausgangssignals an den Aktor mithilfe einer Ausgabeeinrichtung. Erfindungsgemäß wird das wenigstens eine Eingangssignal oder ein auf Grundlage des wenigstens einen Eingangssignals erzeugtes Zwischensignal zur Erzeugung des Ausgangssignals dabei über eine direkte Verbindung zwischen der Aufnahmeeinrichtung und der Ausgabeeinrichtung zur Weiterverarbeitung bereitgestellt.

Insbesondere kann das wenigstens eine, gegebenenfalls vorverarbeitete, Eingangssignal oder das Zwischensignal direkt von der Aufnahmeeinrichtung an die mit der Aufnahmeeinrichtung gekoppelte Ausgabeeinrichtung übermittelt werden, von der es weiterverarbeitet wird. Wird das wenigstens eine, gegebenenfalls vorverarbeitete, Eingangssignal an die Ausgabeeinrichtung übermittelt, kann die Ausgabeeinrichtung im Rahmen der Weiterverarbeitung das Ausgangssignal erzeugen. Wird dagegen das Zwischensignal an die Ausgabeeinrichtung übermittelt, kann die Ausgabeeinrichtung im Rahmen der Weiterverarbeitung das Ausgangssignal auf Grundlage des Zwischensignals erzeugen, zum Beispiel durch Modifikation oder Anpassung des Zwischensignals. In diesem Fall weist das Erzeugen des Ausgangssignals auf Grundlage des wenigstens einen Eingangssignals einen Zwischenschritt auf, der das Erzeugen des Zwischensignals umfasst.

In einer bevorzugten Ausführungsform werden ein Arbeitszyklus der Aufnahmeeinrichtung und ein Arbeitszyklus der Ausgabeeinrichtung miteinander synchronisiert z.B. über die Kopplung / Kopplungssignale selbst. Insbesondere können ein Aufnahmezyklus, in dem die Eingangssignale aufgenommen werden, und ein Ausgabezyklus, in dem das Ausgangssignal ausgegeben wird, aneinander angepasst werden. Durch die Synchronisation der Arbeitszyklen kann die verfügbare Rechenleistung besonders effizient genutzt werden.

Die in Bezug auf den ersten Aspekt der Erfindung und dessen vorteilhafte Ausgestaltung beschriebenen Merkmale und Vorteile gelten, zumindest wo technisch sinnvoll, auch für den zweiten Aspekt der Erfindung und dessen vorteilhafte Ausgestaltung sowie umgekehrt.

Weitere Merkmale, Vorteile und Anwendungsmöglichkeiten der Erfindung ergeben sich aus der nachfolgenden Beschreibung im Zusammenhang mit den Figuren, in denen durchgängig dieselben Bezugszeichen für dieselben oder einander entsprechende Elemente der Erfindung verwendet werden. Es zeigen wenigstens teilweise schematisch:
- FIG 1: ein Beispiel einer Prozesssteuerung nach dem Stand der Technik;
- FIG 2: ein Beispiel eines Peripheriesystems mit einer Logikanordnung; und
- FIG 3: ein Beispiel eines Verfahrens zum Betreiben eines Aktors.

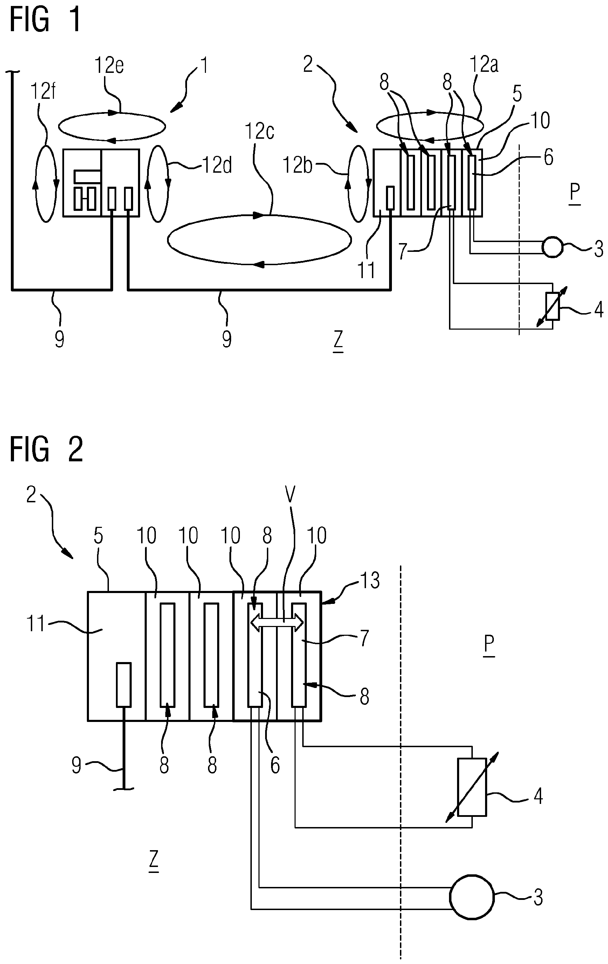

FIG 1 zeigt ein Beispiel einer Prozesssteuerung nach dem Stand der Technik mithilfe einer speicherprogrammierbaren Steuerung 1, welche in einem Peripheriesystem 2 mit einem Sensor 3 und einem Aktor 4 verbunden ist. Über den Sensor 3 hat die speicherprogrammierbare Steuerung 1 Zugriff auf Prozesswerte, welche einen Prozess P charakterisieren, und kann durch die Vorgabe von Stellwerten für den Aktor 4 Einfluss auf den Prozess nehmen.

Das Peripheriesystem 2 umfasst die sog. "dezentrale Peripherie" Z, welche beispielsweise Komponenten bezeichnet, die zur Kommunikation der speicherprogrammierbaren Steuerung 1 mit dem Sensor 3 und Aktor 4 benötigt werden. Das Peripheriesystem 2 umfasst im gezeigten Beispiel eine Schnittstellenstation 5, die eine Aufnahmeeinrichtung 6 zur Aufnahme von Eingangssignalen, die vom Sensor 3 erzeugt werden, und eine Ausgabeeinrichtung 7 zur Ausgabe von Ausgangssignalen, mit denen der Aktor 4 gesteuert oder geregelt werden kann, aufweist. Die Schnittstellenstation 5 kann mehrere solcher Aufnahmeeinrichtungen 6 und/oder Ausgabeeinrichtungen 7 aufweisen. Die Schnittstellenstation 5 ist über ein Feldbussystem an die speicherprogrammierbare Steuerung 1 angeschlossen, weswegen sie auch als "dezentrale Station" bezeichnet werden kann. Da sie mehrere Aufnahmeeinrichtungen 6 und/oder Ausgabeeinrichtungen 7 aufweisen kann wird sie auch als modulare Station bzw. modulare dezentrale Station bezeichnet.

Die Schnittstellenstation 5 ist über einen Feldbus 9 mit der speicherprogrammierbaren Steuerung 1 verbunden. Das Peripheriesystem 2 kann aus mehreren solcher Schnittstellenstationen 5 gebildet werden, was in FIG 1 durch den zweiten, auf der linken Seite der Figur verlaufenden Feldbus 9 angedeutet ist.

Die Aufnahmeeinrichtung 6 und die Ausgabeeinrichtung 7 sind an Anschlussanordnungen 8 der Schnittstellenstation 5 angeschlossen. Solche Anschlussanordnungen 8 können beispielsweise als Klemmblöcke oder Steckplätze ausgebildet sein. Die Schnittstellenstation 5 ist dadurch von einem Benutzer beliebig konfigurierbar, d. h. sie kann je nach Bedarf mit verschieden konfigurierten Komponenten zur Aufnahme bzw. Ausgabe von Signalen bestückt werden.

Die gezeigte Schnittstellenstation 5 ist dabei modular aufgebaut. Sie ist insbesondere aus einzelnen Anschlussmodulen 10 zusammengesetzt, wobei aus Gründen der Übersichtlichkeit nur eines der Anschlussmodule 10 mit einem Bezugszeichen versehen ist. Dabei weist jedes der Anschlussmodule 10 jeweils eine Anschlussanordnung 8 auf.

Die Aufnahme- und Ausgabeeinrichtung 6 sind über die Anschlussanordnungen 8 und die Anschlussmodule 10 an einen Rückwandbus angebunden. Über den Rückwandbus können Signale bzw. Daten an eine Kopfbaugruppe 11 der Schnittstellenstation 5 übertragen werden. Über die Kopfbaugruppe 11 besteht eine Verbindung zum Feldbus 9 und damit zur speicherprogrammierbaren Steuerung 1.

Bei der konventionellen Steuerung des Prozesses P durch die speicherprogrammierbare Steuerung 1 kann, insbesondere bei Prozessen P, die eine zeitlich hochaufgelöste Steuerung benötigen, ein Latenzzeitproblem auftreten, da die unterschiedlichen Komponenten des Peripheriesystems 2 üblicherweise in unterschiedlichen, voneinander unabhängigen Zyklen arbeiten. In der Regel werden zunächst die Eingangssignale zyklisch vom Sensor 3 bereitgestellt bzw. von der Aufnahmeeinrichtungen 6 aufgenommen. Die Übertragung der Eingangssignale bzw. daraus abgeleiteter Information wird im Folgenden durch einen Rückwandbus-Zyklus 12a der Schnittstellenstation 5, einen Kopfbaugruppen-Zyklus 12b, einen Feldbus-Zyklus 12c, einen Feldbusanschluss-Zyklus 12d der speicherprogrammierbaren Steuerung 1 sowie einem Rückwandbus-Zyklus 12e der speicherprogrammierbaren Steuerung 1 beeinflusst. Die Eingangssignale bzw. daraus abgeleitete Informationen werden dann in einem Recheneinheit-Zyklus 12f von der speicherprogrammierbaren Steuerung 1 verarbeitet. Dabei erzeugte Steuerungssignale, auf deren Grundlage nach einer Übertragung zur Ausgabeeinrichtung 7 dort schließlich Ausgabesignale erzeugt werden, durchlaufen die Zyklen 12a-e ein zweites Mal.

FIG 2 zeigt ein Beispiel eines Peripheriesystems 2 mit einer Logikanordnung 13. Das Peripheriesystem 2 weist eine aus mehreren Anschlussmodulen 10 und einer Kopfbaugruppe 11 zusammengesetzte Schnittstellenstation 5 auf. Die Schnittstellenstation 5 ist Teil einer sogenannten "dezentralen Peripherie" Z. Über die Kopfbaugruppe 11 ist die Schnittstellenstation 5 an einen Feldbus 9 angeschlossen, über den sie zum Beispiel mit einer speicherprogrammierbaren Steuerung (siehe FIG 1) verbindbar ist. Jedes der Anschlussmodule 10 weist eine Anschlussanordnung 8, z.B. einen Klemmenblock, auf, die zum Anschluss z.B. von I/O-Baugruppen eingerichtet ist.

Im gezeigten Beispiel sind eine Aufnahmeeinrichtung 6 und eine Ausgabeeinrichtung 7 zur Logikanordnung 13 zusammengeschlossen. Zwischen den Anschlussanordnungen 8, in denen die Aufnahme- und Ausgabeeinrichtung 6, 7 z.B. eingesteckt sind, besteht dabei eine direkte Verbindung V, so dass die Aufnahme- und Ausgabeeinrichtung direkt miteinander gekoppelt sind. Eine solche direkte Verbindung V kann z.B. mithilfe eines Verbindungsmittels wie etwa eines Kabels hergestellt sein. Alternativ oder zusätzlich können die beiden Anschlussanordnungen 8 als ein Terminalblock (nicht dargestellt) ausgebildet sein, an den sowohl Aufnahme- und Ausgabeeinrichtung 6, 7 anschließbar sind und der wiederum gleichzeitig mit beiden Anschlussmodulen 10 verbindbar, z.B. in beide Anschlussmodule 10 einsteckbar, ist. Solch ein Terminalblock kann z.B. als zur direkten Kopplung eingerichteter Klemmenblock mit doppelter Breite ausgebildet sein.

Die direkte Verbindung V, zum Beispiel in Form einer Kopplung, beispielsweise seriell über eine RS-232-Schnittstelle oder auch parallel über ein entsprechendes Bussystem, besteht dabei in bevorzugter Weise parallel zu einem Rückwandbus der Schnittstellenstation 5.

Die Aufnahmeeinrichtung 6 ist mit einem Sensor 3 verbunden und dazu eingerichtet, vom Sensor 3 gebildete Eingangssignale aufzunehmen. Auch wenn im gezeigten Beispiel lediglich ein Sensor 3 gezeigt ist, können auch weitere Sensoren mit der Aufnahmeeinrichtungen 6 verbunden sein. Die Eingangssignale charakterisieren vorzugsweise Prozesswerte eines Prozesses P, zum Beispiel eine Temperatur oder einen Druck eines Prozessfluids, die Winkellage eine Nockenwelle und/oder dergleichen.

Die Ausgabeeinrichtung 7 ist mit dem Aktor 4 verbunden und dazu eingerichtet, ein Ausgangssignal an den Aktor 4 auszugeben. Das Ausgangssignal charakterisiert vorzugsweise einen Stellwert für den Aktor 4. Auch an die Ausgabeeinrichtung 7 können gegebenenfalls weitere Aktoren angeschlossen sein.

Um den Prozess P mithilfe des Aktors 4 in Abhängigkeit von Prozesswerten zu steuern, ist die Logikanordnung 13 dazu eingerichtet, das Ausgangssignal auf Grundlage wenigstens eines Eingangssignals innerhalb der beiden gekoppelten Baugruppen 6, 7 zu erzeugen. Darin unterscheidet sich das in FIG 2 gezeigte Peripheriesystem 2 von dem in FIG 1 gezeigten konventionellen Peripheriesystem, in dem die Steuerlogik, von der die Erzeugung des Ausgangssignals abhängt, von der speicherprogrammierbaren Steuerung ausgeführt wird.

Insbesondere kann die Aufnahmeeinrichtung 6 dazu eingerichtet sein, auf Grundlage wenigstens eines Eingangssignale ein Zwischensignal zu erzeugen und über die direkte Verbindung V an die Ausgabeeinrichtung 7 auszugeben, welche entsprechend dazu eingerichtet sein kann, auf Grundlage des Zwischensignals das Ausgangssignal zu erzeugen. Alternativ kann die Aufnahmeeinrichtung 6 dazu eingerichtet sein, wenigstens ein Eingangssignal über die direkte Verbindung V an die Ausgabeeinrichtung 7 auszugeben, welche entsprechend dazu eingerichtet sein kann, das Ausgangssignal auf Grundlage des wenigstens einen Eingangssignals zu erzeugen. In beiden Fällen können die Aufnahmeeinrichtung 6 und die Ausgabeeinrichtung 7 eine logische Einheit bilden.

Dabei ist es besonders bevorzugt, wenn die logische Verarbeitung des wenigstens einen Eingangssignale von der Ausgabeeinrichtung 7 ausgeführt wird und die Aufnahmeeinrichtungen 6 im Wesentlichen lediglich die Eingangssignale weiterleitet. Dadurch kann im Prinzip eine konventionelle Aufnahmeeinrichtung 6 verwendet werden, die gegebenenfalls lediglich hinsichtlich der Ausgabe der Eingangssignale über die direkte Verbindung V modifiziert sein kann. Die Ausgabe der Eingangssignale über die direkte Verbindung V muss dabei nicht ausschließend sein, sondern kann zusätzlich weiterhin über den Rückwandbus erfolgen, um sie auch an einer speicherprogrammierbaren Steuerung über den Feldbus 9 zum Zwecke anderweitiger Steuerungs- oder Regelungsaufgaben bereitzustellen.

Zur störungsfreien logischen Verarbeitung der Eingangssignale durch die Ausgabeeinrichtung 7 ist es vorteilhaft, die Aufnahmeeinrichtung 6 mit der Ausgabeeinrichtung 7 zu synchronisieren. Dazu kann ein Arbeitszyklus der Aufnahmeeinrichtung 6, in dem z.B. die Eingangssignale aufgenommen werden, an einen Arbeitszyklus der Ausgabeeinrichtung 7, in dem z.B. die Eingangssignale logisch verarbeitet bzw. das Ausgabesignal erzeugt wird, angepasst werden. Die Synchronisation wird vorzugsweise ebenfalls über die direkte Verbindung V durchgeführt.

Gegebenenfalls kann auch die Ausgabeeinrichtung 7 modifiziert sein, und zwar dahingehend, dass Signale nicht (nur) über den Rückwandbus aufgenommen werden, sondern auch über die direkte Verbindung V. Zu diesem Zweck kann die Ausgabeeinrichtung 7 in bevorzugter Weise ein Priorisierungsmodul aufweisen, mit dem die Ausgabeeinrichtung 7, insbesondere selektiv, in einem ersten Betriebszustand zur Aufnahme von (Steuerungs-) Signalen über den Rückwandbus und in einem zweiten Betriebszustand zur Aufnahme von (Eingangs-) Signalen über die direkte Verbindung V betrieben werden kann.

Solche Modifikationen der Eingabe- und/oder Ausgabeeinrichtung 6,7 können dabei zum Beispiel über eine Aktualisierung der Firmware vorgenommen werden. Gegebenenfalls können die Ausgabe- und/oder Aufnahmeeinrichtung 7, 6 aber auch dazu eingerichtet sein, eine z.B. bei der Projektierung des Peripheriesystems 2 durch einen Anwender entworfene Logik zur Verarbeitung des Eingangssignals zu laden und auszuführen.

Es ist auch denkbar spezielle Eingabe- und/oder Ausgabeeinrichtungen herstellerseitig entsprechend auszustatten und als zusammengehörige Komponenten anzubieten.

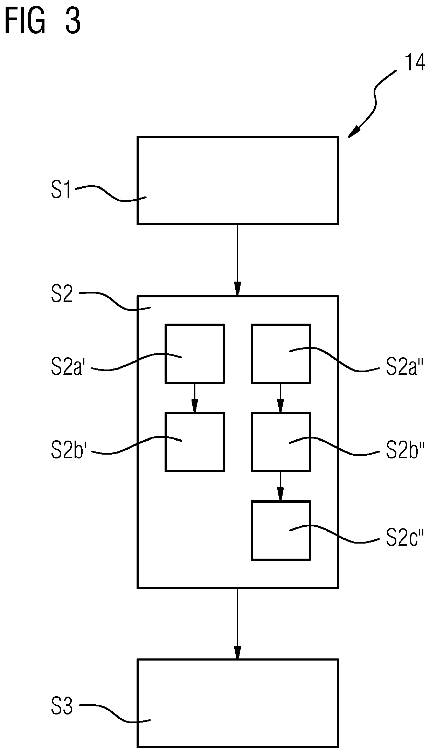

FIG 3 zeigt ein Beispiel eines Verfahrens 14 zum Betreiben eines Aktors, insbesondere mithilfe einer in FIG 2 gezeigten Logikanordnung.

In einem Verfahrensschritt S1 werden von einer Aufnahmeeinrichtung Eingangssignale wenigstens eines Sensors aufgenommen.

In einem weiteren Verfahrensschritt S2 wird auf Grundlage wenigstens eines dieser Eingangssignale ein Ausgangssignal zum Steuern des Aktors erzeugt. Die Erzeugung des Ausgangssignals auf Grundlage des wenigstens einen Eingangssignals findet dabei innerhalb der Logikanordnung statt, die sich vorzugsweise aus der Aufnahmeeinrichtung und einer direkt mit der Aufnahmeeinrichtung gekoppelten Ausgabeeinrichtung zusammensetzt.

In einem weiteren Verfahrensschritt S3 wird das Ausgangssignal von der Ausgabeeinrichtung an den Aktor ausgegeben.

Für die Realisierung der logikanordnungsinternen Erzeugung des Ausgangssignals kann es zwei Alternativen geben:
In einem weiteren Verfahrensschritt S2a' werden die von der Aufnahmeeinrichtung aufgenommenen Eingangssignale über die direkte Kopplung von der Aufnahmeeinrichtung an der Ausgabeeinrichtung zur Weiterverarbeitung bereitgestellt. Daraufhin kann die Ausgabeeinrichtung in einem weiteren Verfahrensschritt S2b' das Ausgangssignal direkt durch logische Verarbeitung des wenigstens einen Eingangssignals erzeugen.

Alternativ erzeugt die Aufnahmeeinrichtung in einem weiteren Verfahrensschritt S2a" auf Grundlage wenigstens eines Eingangssignals ein Zwischensignal. Dieses Zwischensignal wird in einem weiteren Verfahrensschritt 2Sb" über die direkte Verbindung von der Aufnahmeeinrichtung an der Ausgabeeinrichtung zur Weiterbearbeitung bereitgestellt. In einem weiteren Verfahrensschritt S2c" erzeugt die Ausgabeeinrichtung auf Grundlage des Zwischensignals das Ausgabesignal.

### Bezugszeichenliste

- 1: speicherprogrammierbare Steuerung
- 2: Peripheriesystem
- 3: Sensor
- 4: Aktor
- 5: Schnittstellenstation
- 6: Aufnahmeeinrichtung
- 7: Ausgabeeinrichtung
- 8: Anschlussanordnung
- 9: Feldbus
- 10: Anschlussmodul
- 11: Kopfbaugruppe
- 12a-f: Arbeitszyklen
- 13: Logikanordnung
- 14: Verfahren

- P: Prozess
- Z: dezentrale Peripherie
- V: direkte Verbindung

## Patentansprüche

1. Logikanordnung (13) für ein Peripheriesystem (2), insbesondere eines Automatisierungssystems, aufweisend eine Aufnahmeeinrichtung (6) zum Aufnehmen von Eingangssignalen von wenigstens einem Sensor (3) und eine Ausgabeeinrichtung (7) zur Ausgabe eines Ausgangssignals an einen Aktor (4),
**dadurch gekennzeichnet,**
**dass** die Ausgabeeinrichtung (7) und die Aufnahmeeinrichtung 6 direkt miteinander gekoppelt sind und die Logikeinheit (13) dazu eingerichtet ist, über die direkte Kopplung das Ausgangssignal auf Grundlage wenigstens eines Eingangssignals zu erzeugen.

2. Logikanordnung (13) nach Anspruch 1,
**dadurch gekennzeichnet,**
**dass** die Logikanordnung (13) dazu eingerichtet ist, die Aufnahmeeinrichtung (6) und die Ausgabeeinrichtung (7) als logische Einheit zu betreiben.

3. Logikanordnung (13) nach einem der Ansprüche 1 oder 2,
**dadurch gekennzeichnet,**
**dass** die wenigstens eine Aufnahmeeinrichtung (6) und die Ausgabeeinrichtung (7) über einen Terminalblock direkt gekoppelt sind.

4. Logikanordnung (13) nach Anspruch 3,
**dadurch gekennzeichnet,**
**dass** der Terminalblock zum Verbinden mit zwei Anschlussmodulen (10) einer Schnittstellenstation eingerichtet ist.

5. Logikanordnung (13) nach einem der Ansprüche 1 bis 3,
**dadurch gekennzeichnet,**
**dass** die Aufnahmeeinrichtung (6) und die Ausgabeeinrichtung jeweils mit einem Terminalblock verbunden sind und die beiden Terminalblöcke über ein Verbindungsmittel direkt miteinander gekoppelt sind.

6. Logikanordnung (13) nach einem der vorangehenden Ansprüche,
**gekennzeichnet durch**
eine hierarchische Struktur, wobei entweder die Aufnahmeeinrichtung (6) oder die Ausgabeeinrichtung (7) dazu eingerichtet ist, das wenigstens eine Eingangssignal logisch zu verarbeiten.

7. Logikanordnung (13) nach einem der vorangehenden Ansprüche,
**dadurch gekennzeichnet,**
**dass** wenigstens ein Eingangskanal, über den die Eingangssignale von der Aufnahmeeinrichtung (6) aufgenommen werden, mit einem Ausgangskanal, über den das Ausgangssignal von der Ausgabeeinrichtung (7) ausgegeben wird, direkt gekoppelt ist.

8. Logikanordnung (13) nach einem der vorangehenden Ansprüche,
**dadurch gekennzeichnet,**
**dass** die Ausgabeeinrichtung (7) dazu eingerichtet ist, das Ausgangssignal in einem ersten Betriebszustand in Abhängigkeit eines über das Peripheriesystem (2) empfangenen Steuerungssignals und in einem zweiten Betriebszustand in Abhängigkeit eines von der Aufnahmeeinrichtung (6) ausgegebenen Zwischensignals zu erzeugen.

9. Logikanordnung (13) nach einem der vorangehenden Ansprüche,
**dadurch gekennzeichnet,**
**dass** die Logikanordnung (13) dazu eingerichtet ist, Statusinformation in Bezug auf das Ausgangssignal im Peripheriesystem (2) bereitzustellen.

10. Logikanordnung (13) nach einem der vorangehenden Ansprüche,
**dadurch gekennzeichnet,**
**dass** die Logikanordnung (13) dazu eingerichtet ist, eine Kompatibilität der wenigstens einen Aufnahmeeinrichtung (6) mit der Ausgabeeinrichtung (7) in Bezug auf die Erzeugung des Ausgangssignals auf Grundlage des wenigstens einen Eingangssignals zu prüfen.

11. Logikanordnung (13) nach einem der vorangehenden Ansprüche,
**dadurch gekennzeichnet,**
**dass** die Logikanordnung (13) dazu eingerichtet ist, eine Logik zur Erzeugung des Ausgangssignals auf Grundlage wenigstens eines Eingangssignals über das Peripheriesystem (2) zu laden.

12. Peripheriesystem (2) aufweisend eine Logikanordnung (13) nach einem der vorangehenden Ansprüche.

13. Verfahren (14) zum Betreiben eines Aktors (4), insbesondere mithilfe einer Logikanordnung (13) nach einem der Ansprüche 1 bis 11, aufweisend die Schritte:
- Aufnehmen (S1) von Eingangssignalen wenigstens eines Sensors (3) mithilfe einer Aufnahmeeinrichtung (6);
- Erzeugen (S2) eines Ausgangssignals auf Grundlage wenigstens eines Eingangssignals; und
- Ausgeben (S3) des Ausgangssignals an den Aktor (4) mithilfe einer Ausgabeeinrichtung (7),
**dadurch gekennzeichnet,**
**dass** das wenigstens eine Eingangssignal oder ein auf Grundlage des wenigstens einen Eingangssignals erzeugtes Zwischensignal zur Erzeugung des Ausgangssignals über eine direkte Verbindung (V) zwischen der Aufnahmeeinrichtung (6) und der Ausgabeeinrichtung (7) zur Weiterverarbeitung bereitgestellt wird.

14. Verfahren (14) nach Anspruch 13,
**dadurch gekennzeichnet,**
**dass** ein Arbeitszyklus der Aufnahmeeinrichtung und ein Arbeitszyklus der Ausgabeeinrichtung miteinander synchronisiert werden.
